# EUROPÄISCHE PATENTSCHRIFT

(11) **EP 2 112 676 B1**
(45) Veröffentlichungstag und Bekanntmachung des Hinweises auf die Patenterteilung: **20.03.2013**
(21) Anmeldenummer: 09004826.5
(22) Anmeldetag: 01.04.2009
(51) Int. Cl.: H01H 36/00, H03K 17/95

(54) **Vorrichtung zur magnetischen Positionsüberwachung**
Device for magnetic position monitoring
Dispositif de surveillance de position magnétique

(30) Priorität: 03.04.2008 DE 102008017479
(43) Veröffentlichungstag der Anmeldung: 28.10.2009
(73) Patentinhaber: Link GmbH, 35510 Butzbach (DE)
(72) Erfinder: Link, Markus, 65817 Eppstein-Bremthal (DE)
(74) Vertreter: Tergau & Walkenhorst

(56) Entgegenhaltungen:
- DE-A1- 10 349 937
- DE-A1- 19 518 527
- DE-B3-102005 018 826
- UWE LOREIT, JOACHIM ASCHENBACH: "Magnetoresistive Sensoren machen mobil" DRUCKSCHRIFT AUTOMOTIVE, 7. August 2004 (2004-08-07), Seiten 24-27, XP002583497

## Beschreibung

Es ist bekannt, die Schließ- oder Offenstellung eines Fenster- oder Türflügels bzw. die aktuelle Position der zugehörigen Verriegelungseinrichtung berührungsfrei mit Hilfe eines stationär am Rahmen angebrachten Magnetsensors zu erfassen, welcher mit einem am Tür- oder Fensterflügel angeordneten bzw. an einem Riegelbolzen befestigten Dauermagneten zusammenwirkt (vgl.z.B. DE 199 03 468 C1; DE 199 14 568 C2; DE 200 14 841 U1). Als Magnetsensoren kommen in derartigen Öffnungsmeldern in erster Linie Reed-Kontakte und Hall-Sensoren zum Einsatz. Die Zuverlässigkeit einer solchen Positionsüberwachung hängt u.a. davon ab, dass die Bewegungsbahn des Magneten ihre Lage relativ zum Magnetsensor beibehält, sich also nicht im Laufe der Zeit ändert, sich beispielsweise schräg stellt oder gegenüber der ursprünglich eingestellten Lage parallel versetzt ist. In solchen Fällen würde sich die Auslöseposition des Magneten ändern. Das bedeutet beispielsweise, dass der Magnetsensor noch immer eine Offenstellung des Fensters meldet, obwohl dieses bereits seine Schließstellung erreicht hat. Verzieht sich das Fenster oder setzt sich die Tür, so kann dies Fehlmeldungen der magnetischen Positionsüberwachungsvorrichtung zur Folge haben. Unter Umständen wird fälschlich z.B. ein Einbruchsalarm mit all seinen Folgekosten ausgelöst.

Des weiteren zeigt DE 195 18 527 A1 eine Überwachungsanordnung für den Verriegelungszustand eines Fensters oder dergl., dessen Riegelelement mit einem Dauermagneten und dessen Riegeleingriffselement mit mehreren auf das Magnetfeld des Dauermagneten ansprechenden Magnetfeldsensoren in Form von Hall-Elementen ausgestattet ist. Abhängig von den Ausgangssignalen der örtlich im Abstand voneinander angeordneten Magnetfeldsensoren sowie von zumindest einer den Sensoren zugeordneten Referenzgröße erzeugt eine Überwachungsschaltung ein die Verriegelungsstellung oder die Entriegelungsstellung des Riegelelements kennzeichnendes Überwachungssignal. Um eine zeitraubende manuelle Justierung der Sensorik beim Einbau zu vermeiden, ist die Überwachungsschaltung bei geschlossenem Fensterflügel in einer Initialisierungsphase betreibbar, in welcher sie bei verriegeltem Riegelelement, abhängig von den dann erzeugten Ausgangssignalen der einzelnen Magnetfeldsensoren für jeden Magnetfeldsensor eine Referenzgröße festlegt und in einen Speicher einschreibt. Im normalen Überwachungsbetrieb vergleicht die Überwachungsschaltung die Ausgangssignale der Magnetsensoren mit den zugeordneten Referenzgrößen und löst Alarm aus, sofern wenigstens ein Sensorausgangssignal außerhalb eines vorgegebenen Referenzgrößenkorridors liegt.

Im Laufe der Zeit können sich die Ausgangssignale der Magnetsensoren auch bei ordnungsgemäß verriegeltem Riegelelement ändern, beispielsweise weil die Feldstärke des Dauermagneten infolge Alterung abnimmt oder weil sich der Fensterflügel verzieht und sich somit die räumliche Relativlage von Magnet und Sensor ändert. Um hier Abhilfe zu schaffen, sieht DE 195 18 527 A1 für die Referenzgrößen eine automatische Driftkorrektur vor. Die Überwachungsschaltung lässt hierzu die gespeicherten Referenzgrößen mit einer vorbestimmten Änderungsrate oder abhängig von einem zeitlichen Mittelwert der Sensorausgangssignale einer Änderung der in der Verriegelungsstellung von den Magnetsensoren erfassten Feldstärke folgen.

Seit einigen Jahren werden als Positions-, Winkel- oder Magnetfeldsensoren magnetoresistive (MR) Sensoren eingesetzt, welche sich durch hohe Meßpräzision, geringen Stromverbrauch und äußerst kleine Abmessungen auszeichnen. Sie beruhen auf dem sog. "Anisotropen Magneto-Resistiven Effekt" (AMR) oder auf dem "Magneto-Resistiven Rieseneffekt" (Giant Magneto Resistive) (GMR) und sind beispielsweise in einem Aufsatz "Magnetoresistive Sensoren machen mobil" der Druckschrift AUTOMOTIVE 7-8.2004 auf den Seiten 24-27 (Komponenten) beschrieben.

DE 103 49 937 A1 beschreibt eine Einrichtung zur berührungslosen Erfassung der Schaltstellungen von Kfz-Tür- und Zündschlössern. Mit der Betätigung des Schließ- oder Drehzylinders oder der Türverriegelung wird ein zum Drehwinkel oder zur linearen Bewegung der Türverriegelung analoges Signal erzeugt, welches mit Hilfe einer nachfolgenden Elektronik mehrere Schaltfunktionen generiert. Dabei soll die Einrichtung am Sensorort unter verschiedenen Schlüsselstellungen ein durchgehend hohes magnetisches Feldniveau aufweisen. Der Magnetsensor ist ein magnetoresistiver Sensor mit zwei um einen Winkel von 45° gegeneinander verdrehten Wheatstone-Brücken, der zwei Feldkomponenten des Magneten in alaoger Form als Maß der Winkelstellung des Drehzylinders bzw. der Linearbewegung der Türverriegelung erfasst und an eine Auswerteelektronik weitergibt.

Bei einer aus DE 10 2005 018 826 B3 bekannten Vorrichtung zum Erfassen der Riegelposition eines Schwenk/Kippfensters ist der Riegel in wenigstens drei Positionen innerhalb eines ortsfesten Beschlags verstellbar. Diese Riegelpositionen werden mit in mindestens zwei zueinander senkrechten Raumrichtungen gemessenen Magnetfeldstärken eines Pernanentmagnetfeldes erfasst. Als Magnetfeldsensor dient ein Hall-Sensor.

Ziel der vorliegenden Erfindung ist ein Öffnungsmelder der eingangs genannten Art mit Eigenüberwachung, welcher eine etwaige Relativverschiebung seiner die Position erfassenden Komponenten (Magnetteil und/oder Sensor) gegenüber einer vorgegebenen Sollposition anzeigt, wenn die Relativverschiebung nicht durch die betriebsbedingte Bewegung des die Komponenten tragenden Objekts (Tür- oder Fensterflügel) im Betrieb verursacht ist. Die in DE 195 18 527 A1 beschriebene automatische Driftkorrektur birgt insbesondere bei der Stellungsüberwachung eines Tür- oder Fensterflügels ein Sicherheitsrisiko, weil durch Ausnutzung der Driftkorrektur über einen längeren Zeitraum ein vergrößerter Öffnungswinkel verschleiert werden kann und die Überwachungseinrichtung manipulierbar wird.

Zur Lösung der genannten Aufgabe geht die im Anspruch 1 gekennzeichnete Erfindung deshalb einen grundsätzlich anderen Weg. Zum einen erfolgt keine automatische Driftkorrektur sondern eine Driftanzeige, sobald die Drift größer ist als ein vorgegebener Bereich. Andererseits werden keine auf dem galvanomagnetischen Hall-Effekt in Halbleitern beruhenden Hall-Sensoren, sondern z.B. auf einem quantenmechanischen magnetoresistiven Effekt in ferromagnetischen leitfähigen Dünnschichten basierende MR-Sensoren als Magnetfeldsensoren eingesetzt, welche sich gegenüber Hall-Sensoren durch eine wesentliche höhere Magnetfeldempfindlichkeit und räumliche Messgenauigkeit, eine viel geringere Stromaufnahme sowie vor allem durch einen minimalen Platzbedarf auszeichnen. Hiermit lassen sich nicht nur Änderungen der gemessenen Magnetfeldstärke sonder auch räumliche Verschiebungen von Magnetfeldstrukturen sehr genau erkennen.

Ausgehend von der in DE 195 18 527 A1 vorgeschlagenen Überwachungsvorrichtung für einen Tür- oder Fensterriegel betrifft die vorliegende Erfindung eine Vorrichtung gemäß Gattungsbegriff des Anspruchs 1 zur Positionsüberwachung von zwei relativ zueinander beweglichen Objekten, insbesondere eines Fenster- oder Türflügels oder dessen Verriegelung einerseits und eines Fenster- oder Türrahmens andererseits. Gemäß der Erfindung weist der Magnetfeldsensor wenigstens ein magnetoresistives Sensorelement auf, und die Auswerteschaltung liefert ferner ein zur Überprüfung der Meßeinrichtung aufforderndes Hinweissignal, wenn die genannte Abweichung zwar geringer ist als der Grenzwert aber einen unterhalb des Grenzwertes vorgegebenen Anzeigewert überschreitet.

Gegenüber der in DE 195 18 527 A1 vorgesehenen automatischen elektrischen Kompensation der Driftfolgen ermöglicht die Erfindung, ausgelöst durch das eine Drift anzeigende Hinweissignal, eine Beseitungung der Gründe für die Drift, indem z.B. bei der nächsten Wartung der Anlage diese Gründe durch Nachjustieren entweder des Tür- oder Fensterflügels bzw. der Sensoranordnung beseitigt werden. Die Gefahr einer Driftverschleierung oder Manipulierbarkeit wird vermieden.

Ist keine Abweichung vom Sollwert festzustellen, so arbeitet der Öffnungsmelder ordnungsgemäß (evtl. Anzeige grün). Liegt die Abweichung unterhalb eines, gegebenenfalls einstellbaren, noch unkritischen Grenzwertes, so wird dies angezeigt (z.B. gelb), damit die Lage der Sensorkomponenten beim nächsten Wartungszyklus nachjustiert werden kann. Überschreitet die Abweichung den Grenzwert, so wird Alarm ausgelöst (Anzeige rot), weil dann eine zuverlässige Positionsüberwachung des Objekts (z.B Türflügel) nicht mehr gewährleistet ist oder sich das Objekt in einer unzulässigen Stellung befindet. Meldet der MR-Sensor das Überschreiten wenigstens einer vorgebenen Magnetfeldstärke, so zeigt dies an, dass durch Annähern bzw. Auflegen eines Fremdmagneten versucht wird, die Überwachungsanlage zu manipulieren.

Lässt der MR-Sensor eine unzulässige Schwächung oder Verlagerung des Magnetfelds bzw. der Magnetfelder erkennen, so werden spätestens im Zuge der nächstfälligen Inspektion oder Wartung des Öffnungsmelders die Ruheposition und/oder die Bewegungsbahn von Dauermagnet und/oder Sensor nachjustiert. Dies kann auf verschiedene Weise geschehen, beispielsweise durch Richten des Tür- oder Fensterflügels, durch Neuausrichten des beispielsweise in einer Exzenterhalterung gelagerten Sensors (vgl. DE 20 2006 015 541 U1), durch Aufsetzen eines Zusatzmagneten auf einen das auslösende Magnetteil tragenden Riegelbolzen eines Tür- oder Fensterbeschlags (vgl. DE 10 2005 058 405 A1) oder durch andere geeignete Maßnahmen.

Als auf den MR-Sensor einwirkendes Magnetteil kann, wie bislang üblich, ein Dauermagnet dienen. Die hohe Empfindlichkeit von MR-Sensoren kann es aber erlauben, auf einen solchen besonderen Magneten zu verzichten und stattdessen wenigstens ein Magnetteil, beispielsweise ein ferromagnetisches oder weichmagnetisches, also ein magnetisierbares Bauteil zu verwenden, welches ein ohnehin vorhandenes Magnetfeld, z.B. das erdmagnetische Feld, örtlich strukturiert, insbesondere konzentriert, so dass eine bestimmte Feldstruktur für den MR-Sensor erkennbar wird. Um die Messbarkeit einer solchen Feldstruktur zu erleichtern, kann das Magnetteil aus mehreren, eine Feldkodierung bewirkenden Sektionen zusammengesetzt sein.

Will man zur Überprüfung der ordentlichen Arbeitsweise des Öffnungsmelders nicht nur eine eventuelle Schwächung des Magnetfelds sondern auch einen Versatz desselben ermitteln, so kann man beispielsweise im Bereich einer Endlage des beweglichen Objekts mehrere MR-Sensoren um die Soll-Bewegungsbahn des Magnetteils oder dessen Endposition räumlich verteilt anordnen und durch Vergleich der Feldstärkemeßwerte der einzelnen Sensoren feststellen, ob, wie stark und in welche Richtung die Bewegungsbahn in diesem Bereich verschoben ist. Auch hier kann eine jenseits eines vorgegebenen Grenzwertes liegende Abweichung durch ein Warnsignal das Wartungspersonal darauf hinweisen, dass einen Nachjustierung ratsam ist. Ist eine mechanische Nachjustierung des das Magnetteil tragenden Objekts nicht möglich, kann man die Abweichung u.U. dadurch kompensieren, dass die Meßsignale der einzelnen MR-Sensoren in der Auswerteschaltung unterschiedlich gewichtet werden. Unter Ausnutzung des erdmagnetischen Feldes lässt sich z.B. bei gleichem Öffnungsgrad des Fensters feststellen, ob das Fenster in die Offenstellung geschwenkt oder gekippt wurde. Generell lassen sich dank der äußerst geringen Abmessungen von MR-Sensoren durch diese nicht nur skalare Größen, wie die Magnetfeldstärke, sondern durch den Einsatz mehrerer solcher Sensoren in gedrängter Anordnung auch Vektorgrößen, wie die Feldrichtung ermitteln.

Vorteilhafte Ausgestaltungen und Weiterbildungen der Erfindung ergeben sich aus den Unteransprüchen. Sie wird nachfolgend anhand in der Zeichnung schematisch wiedergegebener Ausführungsbeispiele erläutert. Darin zeigt
- Fig.: 1 einen aus Magnetteil und Magnetfeldsensor bestehenden Öffnungsmelder, wenn sich Magnetteil und Sensor in paralleler Ausrichtung gegenüberstehen;
- Fig.2: einen Öffnungsmelder, bei dem sich Magnetteil und Sensor stirnseitig gegenüberstehen;
- Fig.3: die Komponenten eines Magnetfeldsensors;
- Fig.4: die Zuordnung einzelner Betriebszustände des zu überwachenden Objekts und des Öffnungsmelders zu den gemessenen Werten der magnetischen Feldstärke H.

Der Dauermagnet M ist im Fall eines Öffnungsmelders am Tür- oder Fensterflügel befestigt und kann auch aus mehreren Teilmagneten zusammengesetzt sein. Er bewegt sich mit dem Türflügel in Richtung des Pfeils P auf den ortsfest am Tür- bzw. Fensterrahmen gehaltenen Magnetfeldsensor S zu bzw. von diesem weg; und zwar auf einer vorgebenen Bewegungsbahn, welche im Fall einer Schwenkbewegung gekrümmt ist. Je mehr sich der Magnet M dem Sensor S nähert, umso höher ist die von diesem gemessene Stärke des Magnetfeldes bzw. der Magnetfelder. Der Sensor S steht entweder über ein Kabel L oder über eine Antenne A und eine Funkstrecke mit einer ortsfesten Überwachungszentrale in Verbindung.

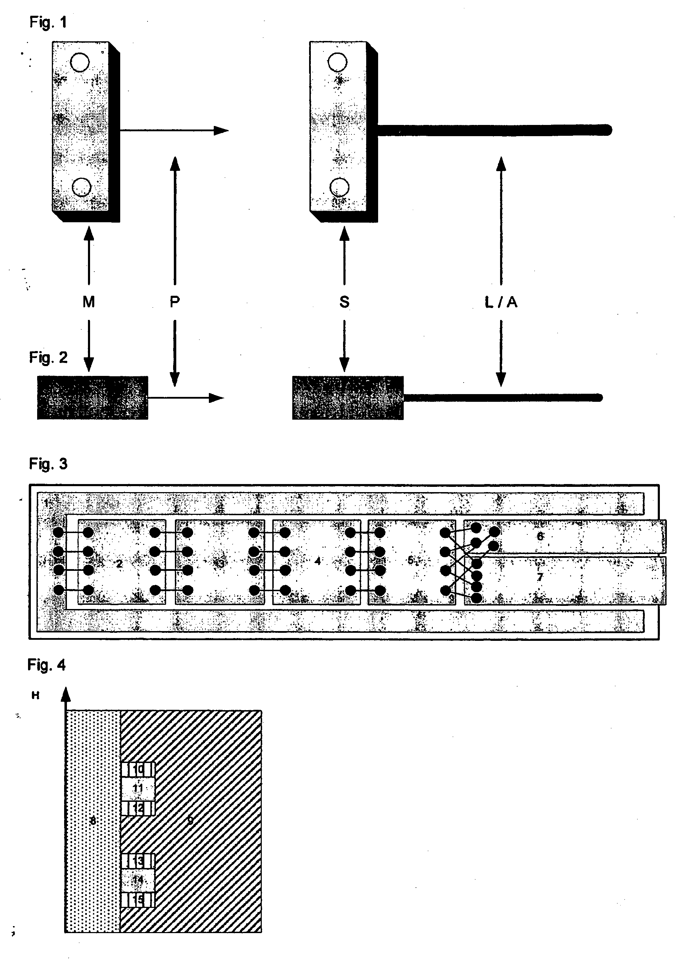

Der in Fig.3 gezeigte Sensor enthält als magnetfeldempfindliche Elemente eine oder mehrere Brückenschaltungen aus magnetoresistiven Sensorelementen, wie dies im eingangs erwähnten Aufsatz sowie in Produktbeschreibungen der Hersteller magnetoresistiver Magnetfeldsensoren erläutert ist. Die als Microchip ausgebildete Brückenschaltung 1 ist ausgangsseitig an einen Microcontroller 2 angeschlossen, welcher zusammen mit weiteren auf dem Chip angeordneten Baugruppen eine Auswerteschaltung für die gemessene Magnetfeldstärke bildet. Zu diesen Baugruppen, deren Funktion auch im Microcontroller realisiert sein kann, können beispielsweise eine Anpassungsschaltung 3 zum Anschluss an einen Signalübertragungsbus L oder eine Treiberschaltung 3 zum Anschluss an eine Funkantenne A oder eine Ausgangsstufe 3 zum Einspeisen der Meßsignale oder hieraus abgeleiteter Signale in eine mehradrige Leitung L gehören. Ferner kann eine Schutzschaltung 4 zur Gewährleistung elektromagnetischer Verträglichkeit EMV vorgesehen sein sowie ein Feld 5 mit Lötkissen für den Leitungsanschluss. Schließlich sind eine stabilisierte Spannungsversorgung 6 mit Batterie oder Akkumulator und Ladeschaltung, gegebenenfalls gespeist über Funk, sowie alternativ ein Kabelanschluss 7 zur Stromversorgung und/oder leitungsgebundenen Signalübertragung vorhanden.

Ein Öffnungmelder soll normalerweise feststellen, ob ein Fenster oder eine Tür tatsächlich geschlossen und gegebenfalls auch verriegelt ist. Hierzu schaltet im Stand der Technik ein am oder im Türflügel angeordneter Dauermagnet beim Erreichen der Schließlage einen am Türrahmen angebrachten Reed-Kontakt um, welcher einen Überwachungsstromkreis schließt bzw. unterbricht. Die Schließlage einer Tür wird mechanisch definiert, nämlich wenn die Tür am Rahmen anliegt. Nach der Erfindung wird anstelle des Reed-Kontakts bzw. der in DE 195 18 527 vorgesehenen Hall-Sensoren als Magnetsensor ein magnetoresistiver Sensor eingesetzt, dessen in der Schließlage der Tür erzeugtes Endlagensignal nicht nur ein einen vorgegebenen Schaltpegel überschreitendes Schaltsignal ist. Vielmehr ist das Ausgangssignal des magnetoresistiven Feldsensors sowohl in der Endlage als auch in jeder anderen Position des vom Türflügel getragenen Magneten zur jeweils am Feldsensor herrschenden magnetischen Feldstärke proportional. Schließt die Tür nicht, entweder weil der Antrieb nicht richtig funktioniert oder weil ein Hindernis das Schließen verhindert, so liefert der Sensor kein Endlagensignal, so dass ein entsprechendes Anzeige- oder Alarmsignal erzeugt wird.

Geht die Tür mechanisch ordnungsgemäß in den Schließzustand und liegt das vom Magnetsensor gelieferte Signal zwar oberhalb des Ansprechwerts des Endlagensignals aber gleichwohl unterhalb eines vorgegebenen, im Microcontroller gespeicherten, den Ansprechwert übersteigenden Mindestwerts, so bedeutet das, dass Magnetteil und Sensor in der Schließlage weiter voneinander entfernt sind, als bei ordnungsgemäßer Relativlage der Bewegungsbahn des Magnetteils gegenüber der Position des Sensors. Zumindest in dieser Endlage ist also die Bewegungsbahn des Magnetteils gegenüber ihrem Sollverlauf räumlich verschoben. Die Auswerteschaltung zeigt dann (z.B. grün) zutreffender Weise das Erreichen der Schließstellung der Tür an, erzeugt aber zusätzlich oder alternativ ein Abweichungssignal (z.B. gelb), welches erkennen läßt, dass sich die Relativlage von Magnetteil-Bewegungsbahn und Sensorposition zueinander gegenüber der ursprünglichen Einstellung geändert hat. Diese Abweichungsanzeige veranlasst eine Überprüfung von Magnetteil- und/oder Sensor-Justierung beim nächsten Wartungszyklus. Gegebenenfalls ist es ratsam, die Soll-Magnetfeldstärke(n) in beiden Endlagen des beweglichen Objekts abzuspeichern und mit den aktuell gemessenen Werten zu vergleichen. Dann erkennt man z.B., ob sich der Fensterflügel verzogen oder gesenkt hat.

Nach der gleichen Methode lassen sich der Schaltabstand bei der Annäherung von Magnetteil und Sensor sowie der Schaltabstand beim Entfernen des Magnetteils vom Sensor und auch die Breite des zulässigen Abweichungsbereichs ermitteln und ggf. einstellen. Des weiteren kann durch Auswerten des der tatsächlichen Magnetfeldstärke proportionalen Sensor-Ausgangssignals festgestellt werden, ob beispielsweise im Zug einer Sensormanipulation, durch Auflegen eines Fremdmagneten versucht wurde, eine Schließstellung der Tür vorzutäuschen. Nach der Installation von Sensor und Magnet kann man wegen der hohen Empfindlichkeit von magnetoresistiven Sensoren die Magnetfeldstärke in wenigstens einer Kipplage des Fensters messen und als elektrische Größe abspeichern. Wird dann im Betrieb das Fenster langsam geöffnet, so lässt sich durch kontinuierliches Messen der Magnetfeldstärke erkennen, wenn es diese Kipplage durchläuft.

In Fig.4 befinden sich innerhalb eines hier der Einfachheit halber als rechteckige Fläche dargestellten Bereichs messbarer Magnetfeldstärken H verschiedene Zonen 8 bis 15, welchen vorgegebene Bedeutungen zugeordnet sind. Ein zeitlicher oder räumlicher, beispielsweise vom Schwenk- oder Kippwinkel des Fensters abhängiger, Verlauf der Magnetfelsstärke ist absichtlich nicht eingezeichnet, weil er je nach Konstruktion des Fensters, Anordnung und Empfindlichkeit der Sensoren und anderen Konstruktionsmerkmalen sowie abhängig von der anstehenden Überwachungsaufgabe ganz unterschiedliche Gestalt annehmen kann. Eingetragen in diese schematisierte Darstellung sind als Beispiel lediglich zwei Zonentripel 10 bis 12 und 13 bis 15, welchen eine besondere Bedeutung zukommt. Die Lage dieser Zonentripel innerhalb des Gesamtbereichs hängt, wie erwähnt, von verschiedenen, z.T. zuvor erwähnten Faktoren ab, beispielsweise vom vorgeschriebenen oder erwarteten Verlauf der Magnetfeldstärke H in Abhängigkeit vom Schwenkwinkel.

Die Zone 11 entspricht z.B. dem Sollwert der Magnetfeldstärke bei geschlossenem Fenster (Endlage I). Zu beiden Seiten dieser Zone 11 befindet sich je eine Abweichungszone 10 bzw. 12. Wird ein in einer dieser beiden Anweichungszonen liegender Feldstärkewert gemessen, so wird zwar der Überwachungsanlage ein Fenster im Schließzustand gemeldet (grün). Zugleich (oder statt dessen) wird angezeigt, dass beispielsweise infolge Verformung des Fensters der Meßwert in dieser (mechanisch definierten) Endlage I vom eigentlichen Sollwert 11 abweicht, allerdings noch innerhalb eines vorgegebenen Toleranzkorridors 10,12 liegt. Diese Anzeige fordert den Wartungsdienst auf, beim nächsten Wartungszyklus die Funktion dieser Meßstelle, inbesondere die relative Lage von Sensor und Magnetteil zu überprüfen. Vielleicht hat sich das Fenster oder seine Lagerung verzogen.

Eine ähnliche Bedeutung haben die Zonen 13 bis 15, diesmal bezogen auf eine andere Endlage II des Fensters, beispielsweise die Endlage bei voll göffnetem bzw. gekipptem Fenster. Auch hier liegt zu beiden Seiten der Sollwertzone 14 je eine Abweichungszone 13 bzw. 15. Wird eine in einer diesere beiden Abweichungszonen liegende Magnetfeldstärke gemessen, so erscheint eine, wie zuvor beschriebene Anzeige, welche zur Überprüfung im nächsten Wartungszyklus auffordert.

Die an die Sensorelemente angeschlossene Auswerteschaltung kann aus der zeitlichen Reihenfolge der gemessenen Feldstärkewerte, also z.B. 10,11,12 oder 12,11,10 erkennen, in welcher Richtung der Sollwert 11 angefahren wird. Daraus ergibt sich beispielsweise, ob sich das vom beweglichen Objekt getragene Magnetteil in Einschaltrichtung oder in Abschaltrichtung bewegt.

Eine weitere, ebenfalls nur schematisch angedeutete Zone 8 umfasst Feldstärkewerte, welche darauf schließen lassen, dass beispielsweise durch Auflegen eine Fremdmagneten versucht wurde, die Meßvorrichtung zu manipulieren, etwa einen Schließzustand des Fensters vorzutäuschen.

Schließlich zeigt ein in der Alarmzone 9 liegender Meßwert an (rot), dass das Fenster offen ist. Die Breite und Lage der genannten Zonen sowie gegebenenfalls weiterer Zonen mit fest zugeordneter Bedeutung hängt, wie erwähnt, von den Gegebenheiten des Einzelfalls ab. Die einer Sollwertzone zugeordneten Abweichungszonen können unterschiedlich breit oder es kann überhaupt nur auf einer Seite der Sollwertzone eine Zone zulässiger Abweichung vorgesehen sein.

Die Erfindung kann im Bedarfsfall dahingehend abgewandelt werden, dass zur Endlagenerkennung wie bisher üblich ein Reed-Kontakt als Magnetsensor eingesetzt wird und die Auswertung der vom MR-Sensor gemessenen aktuellen Magnetfeldstärke in der zuvor geschilderten Weise nunmehr zur Funktionsüberwachung dieses Reed-Kontakts und seiner Bewegungsbahn herangezogen wird. Während der Kalibrierung des Öffnungsmelders kann man den beispielsweise vom jeweiligen Kippwinkel des Fensters abhängigen Verlauf der Magnetfeldstärke ermitteln und ggf. im Microcontroller abspeichern, so dass dieser während der Öfnnungs- oder Schließbewegung auftretende magnetische oder mechanische Störungen erkennen und zur Anzeige bringen kann.

## Patentansprüche

1. Vorrichtung zur Positionsüberwachung von zwei relativ zueinander beweglichen Objekten, insbesondere eines Fenster- oder Türflügels oder dessen Verriegelungseinrichtung einerseits, und eines Fenster- bzw. Türrahmens andererseits, unter Verwendung wenigstens eines an dem einen Objekt angebrachten Magnetteils sowie wenigstens eines am anderen Objekt angebrachten Magnetfeldsensors, welcher in wenigstens einer Endlage des beweglichen Objekts ein Endlagensignal liefert; und wobei
a) eine an den Magnetfeldsensor ausgangsseitig angeschlossene Auswerteschaltung in einer vorgegebenen Relativlage der beiden Objekte zueinander ein der vom Magnetsensor gemessenen Magnetfeldstärke entsprechendes Signal mit einem gespeicherten Sollwert vergleicht und
b) ein Warnsignal erzeugt, sofern die Abweichung der gemessenen Magnetfeldstärke vom Sollwert größer ist als ein vorgegebener, zulässiger Grenzwert;
**dadurch gekennzeichnet, dass**
c) der Magnetfeldsensor (1) wenigstens ein magnetoresistives Sensorelement aufweist; und
d) die Auswerteschaltung (2) ferner ein zur Überprüfung der Meßvorrichtung auffordendes Hinweissignal liefert, wenn die genannte Abweichung zwar geringer ist als der Grenzwert aber einen unterhalb des Grenzwertes vorgegebenen Anzeigewert überschreitet.

2. Vorrichtung nach Anspruch 1, **dadurch gekennzeichnet, dass** die vorgegebene Relativlage der beiden Objekte eine der Endlagen des beweglichen Objekts ist.

3. Vorrichtung nach Anspruch 1 oder 2, **dadurch gekennzeichnet, dass** das an dem einen Objekt angebrachte Magnetteil aus wenigstens einem Permanentmagneten besteht.

4. Vorrichtung nach Anspruch 1 oder 2, **dadurch gekennzeichnet, dass** das an dem einen Objekt angebrachte Magnetteil ein weichmagnetisches oder ein ferromagnetisches Bauteil ist, welches ein ohnehin vorhandenes Magnetfeld örtlich strukturiert, insbesondere konzentriert.

5. Vorrichtung nach Anspruch 4, **dadurch gekennzeichnet, dass** das Magnetteil aus mehreren der Kodierung dienenden Sektionen besteht.

6. Vorrichtung nach einem der Ansprüche 1 bis 5, **dadurch gekennzeichnet, dass** die Auswerteschaltung (2) einen Microcontroller umfasst.

7. Vorrichtung nach Anspruch 6, **dadurch gekennzeichnet, dass** der Microcontroller (2) eine Anpassungsschaltung (3) zum Anschluß an einen Signalübertragungsbus (L) aufweist.

8. Vorrichtung nach Anspruch 6, **dadurch gekennzeichnet, dass** der Microcontroller (2) eine Treiberschaltung (3) zum Anschluß an eine Funksendeantenne (A) aufweist.

9. Vorrichtung nach Anspruch 6, **dadurch gekennzeichnet, dass** der Microcontroller (2) eine Ausgangsstufe (3) zum Einspeisen der Meß- oder Abweichungssignale in eine mehradrige Leitung (L) aufweist.

10. Vorrichtung nach einem der Ansprüche 1 bis 6, **dadurch gekennzeichnet, dass** die Auswerteschaltung (2) eine Vergleichssschaltung umfasst, welche beim Überschreiten einer vorgegebenen Magnetfeldstärke ein Fremdfeld-Anzeigesignal liefert.

11. Vorrichtung nach einem der Ansprüche 1 bis 10, **dadurch gekennzeichnet, dass** die Auswerteschaltung (2) eine Schutzschaltung (4) zur Gewährleistung elektromagnetischer Verträglichkeit (EMV) umfasst.

12. Vorrichtung nach einem der Ansprüche 1 bis 11, **dadurch gekennzeichnet, dass** der Auswerteschaltung (2) eine Batterie (6) oder ein Akkumulator samt Ladeschaltung zugeordnet ist.

13. Vorrichtung nach einem der Ansprüche 1 bis 12, **dadurch gekennzeichnet, dass** der Magnetsensor (1) wenigstens eine aus vier magnetoresistiven Sensorelementen bestehende Brückenschaltung aufweist.

## Claims

1. A device for position monitoring of two objects movable relative to each other, in particular a window or door wing or its locking device, on the one hand, and a window or door wing, on the other hand, using at least one magnet part fixed on the one object as well as at least one magnetic-field sensor fixed on the other object, which in at least one end position of the movable object supplies an end-position signal; and wherein
a) an evaluation circuit connected to the output side of the magnetic-field sensor compares in a predefined position of the two objects relative to each other a signal corresponding to the magnetic-field strength measured by the magnetic-field sensor with a stored setpoint value and
b) generates an alert signal if the deviation of the measured magnetic-field strength from the setpoint value is larger than a predefined admissible limit value;
**characterized in that**
c) the magnetic-field sensor (1) includes at least one magnetoresistive sensor element; and
d) the evaluation circuit (2) supplies, furthermore, an indicating signal requesting a verification of the measuring device if the above-mentioned deviation is smaller than the limit value, but exceeds a predefined indication value which lies below the limit value.

2. The device of claim 1, **characterized in that** the predefined relative position of the two objects is one of the end positions of the movable object.

3. The device of claim 1 or 2, **characterized in that** the magnet part fixed on the one object consists of at least one permanent magnet.

4. The device of claim 1 or 2, **characterized in that** the magnet part fixed on the one object is a soft magnetic or a ferromagnetic component, which locally structures, in particular concentrates, a magnetic field which exists anyway.

5. The device of claim 4, **characterized in that** the magnet part consists of several sections serving for coding.

6. The device of any of claims 1 to 5, **characterized in that** the evaluation circuit (2) comprises a microcontroller.

7. The device of claim 6, **characterized in that** the microcontroller (2) includes an adaptation circuit (3) for connection to a signal-transmitting bus (L).

8. The device of claim 6, **characterized in that** the microcontroller (2) includes a driver circuit (3) for connection to a radio transmitting antenna (A).

9. The device of claim 6, **characterized in that** the microcontroller (2) includes an output stage (3) for feeding the measurement signals or deviation signals into a multi-wired line (L).

10. The device of any of claims 1 to 6, **characterized in that** the evaluation circuit (2) comprises a comparator circuit, which supplies an interfering-field indicating signal when a predefined magnetic-field strength is exceeded.

11. The device of any of claims 1 to 10, **characterized in that** the evaluation circuit (2) comprises a protective circuit (4), in order to guarantee electromagnetic compatibility (EMC).

12. The device of any of claims 1 to 11, **characterized in that** a battery (6) or an accumulator including a charging circuit is associated with the evaluation circuit (2).

13. The device of any of claims 1 to 12, **characterized in that** the magnetic-field sensor (1) includes at least one bridge circuit consisting of four magnetoresistive sensor elements.

## Revendications

1. Dispositif pour le monitorage des positions de deux objets mobiles relativement l'un à l'autre, en particulier d'un vantail de fenêtre ou de porte ou de son dispositif de verrouillage, d'un côté, et d'un vantail de fenêtre ou de porte, de l'autre côté, en utilisant au moins une partie d'aimant fixée à l'un des objets ainsi qu'au moins un capteur de champ magnétique fixé à l'autre des objets, qui, dans au moins une position finale de l'objet mobile founit un signal de position finale; et dans lequel
a) un circuit d'évaluation raccordé au côté de sortie du capteur de champ magnétique compare, dans une position prédéfinie des deux objets relativement l'un à l'autre, un signal correspondant à l'intensité du champ magnétique mesurée par le capteur de champ magnétique avec une valeur de consigne enregistrée et
b) génère un signal avertisseur si la déviation de l'intensité du champ magnétique mesurée, de la valeur de consigne est plus grande qu'une valeur limite admissible prédéfinie;
**caractérisé en ce que**
c) le capteur de champ magnétique (1) comprend au moins un élément de capteur magnétorésistif; et
d) le circuit d'évaluation (2) fournit, en outre, un signal indicateur invitant à une vérification du dispositif de mesurage si la déviation sus-mentionnée est plus petite que la valeur limite, mais excède une valeur d'indication prédéfinie qui est plus basse que la valeur limite.

2. Dispositif selon la revendication 1, **caractérisé en ce que** la position relative prédéfinie des deux objets est une des positions finales de l'objet mobile.

3. Dispositif selon la revendication 1 ou 2, **caractérisé en ce que** la partie d'aimant fixée à l'un des objets se compose d'au moins un aimant permanent.

4. Dispositif selon la revendication 1 ou 2, **caractérisé en ce que** la partie d'aimant fixée à l'un des objets est un composant magnétique doux ou un composant ferromagnétique qui structure, en particulier concentre, localement un champ magnétique qui existe de toute façon.

5. Dispositif selon la revendication 4, **caractérisé en ce que** la partie d'aimant se compose de plusieurs sections servant à la codification.

6. Dispositif selon l'une quelconque des revendications 1 à 5, **caractérisé en ce que** le circuit d'évaluation (2) comprend un microcontrôleur.

7. Dispositif selon la revendication 6, **caractérisé en ce que** le microcontrôleur (2) comprend un circuit d'adaptation (3) pour être raccordé à un bus de transmission de signaux (L).

8. Dispositif selon la revendication 6, **caractérisé en ce que** le microcontrôleur (2) comprend un circuit pilote (3) pour être raccordé à une antenne de transmission par radio (A).

9. Dispositif selon la revendication 6, **caractérisé en ce que** le microcontrôleur (2) comprend un étage de sortie (3) pour alimenter les signaux de mesurage ou les signaux de déviation dans une ligne multiconducteur (L).

10. Dispositif selon l'une quelconque des revendications 1 à 6, **caractérisé en ce que** le circuit d'évaluation (2) comprend un circuit comparateur qui fournit un signal indicateur d'un champ parasite lorsqu'une intensité prédéfinie du champ magnétique est excédée.

11. Dispositif selon l'une quelconque des revendications 1 à 10, **caractérisé en ce que** le circuit d'évaluation (2) comprend un circuit protecteur (4), à fin de garantir la compatibilité électromagnétique (CEM).

12. Dispositif selon l'une quelconque des revendications 1 à 11, **caractérisé en ce qu'**une batterie (6) ou un accumulateur y compris un circuit de charge est assigné au circuit d'évaluation (2).

13. Dispositif selon l'une quelconque des revendications 1 à 12, **caractérisé en ce que** le capteur de champ magnétique (1) comprend au moins un circuit en pont se composant de quatre éléments de capteur magnétorésistif.
